(19) Europäisches Patentamt

European Patent Office

Office européen des brevets

(11) **EP 0 762 147 B1**

(12) **FASCICULE DE BREVET EUROPEEN**

(45) Date de publication et mention
de la délivrance du brevet:
**09.02.2000 Bulletin 2000/06**

(51) Int Cl.⁷: **G01V 3/10**

(21) Numéro de dépôt: **96401916.0**

(22) Date de dépôt: **05.09.1996**

(54) **Détecteur de proximité inductif universel**

Universeller induktiver Näherungsschalter

Universal inductive proximity detector

(84) Etats contractants désignés:
**CH DE ES GB IT LI**

(30) Priorité: **08.09.1995 FR 9510642**

(43) Date de publication de la demande:
**12.03.1997 Bulletin 1997/11**

(73) Titulaire: **Schneider Electric Industries SA**
**92100 Boulogne Billancourt (FR)**

(72) Inventeurs:
• **Guichard, Christophe**
**16000 Angouleme (FR)**
• **Even, Stéphane**
**16000 Angouleme (FR)**

(74) Mandataire: **Carias, Alain**
**Schneider Electric Industries SA,**
**Service Propriété Industrielle,**
**33 bis, avenue du Maréchal Joffre**
**92000 Nanterre (FR)**

(56) Documents cités:
**EP-A- 0 670 505        FR-A- 2 069 347**
**FR-A- 2 074 878        US-A- 4 182 986**

**Description**

La présente invention concerne un détecteur de proximité inductif universel, c'est-à-dire capable de détecter aussi bien des objets magnétiques que des objets amagnétiques, avec une portée de détection qui est sensiblement identique dans l'un et l'autre cas.

Les détecteurs de proximité inductifs comprennent généralement un oscillateur analogique muni d'un circuit oscillant LC qui présente une résistance de pertes équivalente R et qui est excité par une source de courant, l'oscillateur étant agencé pour traduire l'approche d'un objet métallique en une variation analogique d'une grandeur caractéristique de l'oscillation, particulièrement d'une variation de l'amplitude de celle-ci résultant de la modification de la résistance de pertes équivalente R.

La détection à la même distance d'objets magnétiques et d'objets amagnétiques a déjà été maintes fois réalisée ou proposée (voir par exemple EP-A-0 670 505).

Dans le document EP-393 359, il est ainsi décrit un détecteur de proximité inductif présentant un circuit oscillant alimenté par un courant continu représentatif de l'amplitude d'une oscillation fournie par un oscillateur à quartz. Ce détecteur nécessite un étalonnage de l'impédance et de la fréquence propre du circuit oscillant au point d'intersection de courbes caractéristiques obtenues respectivement avec un objet ferreux et avec un objet non ferreux.

Le document EP-399 563 montre un détecteur de proximité inductif capable de détecter des objets magnétiques et des objets amagnétiques en utilisant à cet effet deux circuits oscillants LC, la bobine de l'un étant influençable par un objet magnétique et la bobine de l'autre ne l'étant pas.

Il est d'autre part connu (document DE-33 20 509) d'alimenter le circuit oscillant d'un oscillateur à émetteurs couplés au moyen d'une source de courant constant commandée à la fréquence de l'oscillateur. Ce dispositif ne permet pas une détection universelle au sens précédemment indiqué.

L'invention a pour but de permettre au moyen d'un détecteur de proximité inductif de détecter des objets magnétiques et des objets amagnétiques sensiblement à la même distance, et cela par des mesures simples et peu onéreuses.

Selon l'invention, le détecteur comprend un oscillateur analogique à circuit oscillant LC et:

- un oscillateur pilote délivrant une onde de fréquence fixe et couplé à une entrée de commande de la source de courant de l'oscillateur analogique,

- l'oscillateur analogique et l'oscillateur pilote étant accordés par des moyens d'accord en fréquence,

- la source de courant étant commandée par l'oscillateur pilote pour délivrer en présence et en l'absence d'objet un courant continu périodique de fréquence égale à la fréquence de l'onde pilote et en phase avec celle-ci.

De préférence, le courant périodique traversant la résistance de perte équivalente du circuit oscillant se présente sous forme de créneaux de largeur variable en fonction du déphasage de l'oscillation de l'oscillateur analogique par rapport à celle de l'oscillateur pilote.

L'oscillateur analogique est avantageusement du type à émetteurs couplés, les créneaux du courant périodique étant délivrés par la source de courant pendant les alternances négatives de l'oscillation analogique.

La description va être faite à présent d'une forme d'exécution de l'invention, en regard des dessins annexés.

- la figure 1 est un schéma synoptique d'un détecteur de proximité inductif conforme à l'invention.

- la figure 2 représente un exemple de réalisation d'une partie du détecteur de la figure 1.

- la figure 3 représente la tension fournie par l'oscillateur pilote,

- les figures 4A, 4B, 5A, 5B, 6A, 6B, représentent les tensions d'oscillation et les courants d'excitation du circuit oscillant pour différents états de fonctionnement du détecteur.

- la figure 7 illustre une partie du détecteur dans une application à détection sélective.

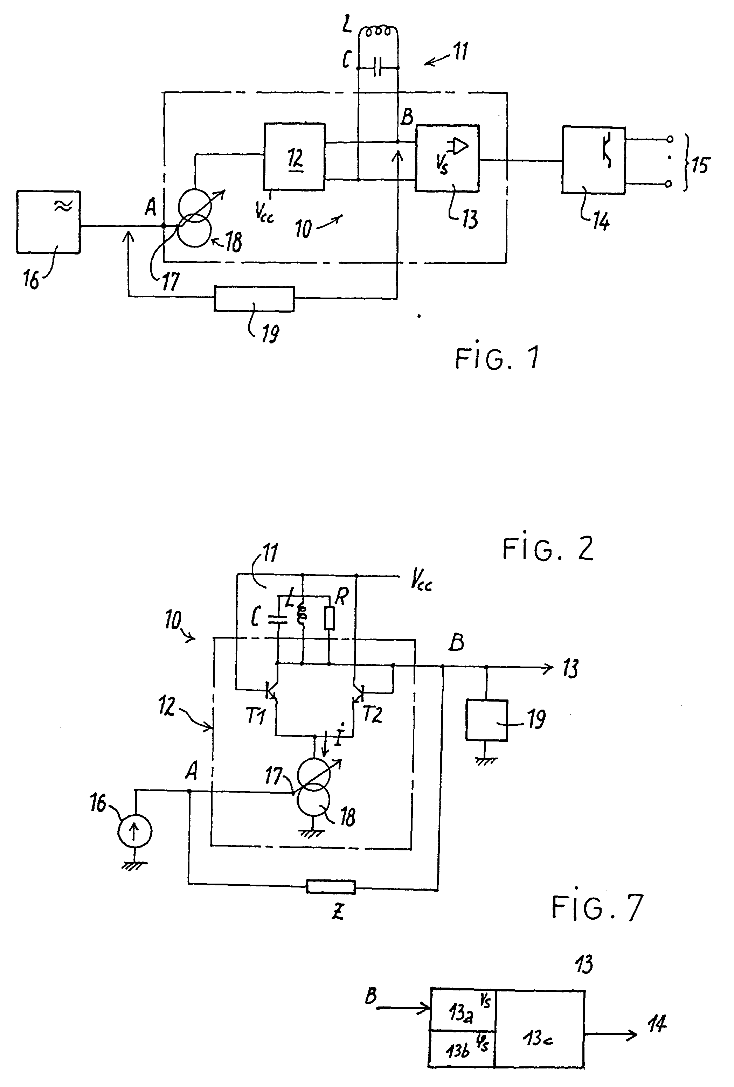

Le détecteur de proximité inductif illustré sur la figure 1 est destiné à détecter, indifféremment et à la même portée, des objets métalliques magnétiques et amagnétiques. Il comprend un oscillateur analogique 10 présentant d'une part un circuit oscillant 11 constitué par le montage parallèle d'une capacité C et d'une bobine d'inductance L influençable par l'objet à détecter, d'autre part divers éléments actifs et passifs figurés en 12. L'oscillateur analogique oscille nominalement avec la fréquence de résonance $1/2\,\pi\,\sqrt{LC}$ du circuit oscillant et qui a pour fonction de délivrer à une borne B une oscillation entretenue en permanence, dont les caractéristiques sont modifiées lorsqu'un objet métallique s'approche de la bobine.

L'oscillation disponible en B est appliquée à un circuit de traitement 13 qui comprend par exemple un détecteur de l'amplitude crête de l'oscillation et un comparateur qui compare l'amplitude crête détectée avec une valeur de seuil $V_S$ représentative de la portée de détection propre au détecteur. Le signal de sortie du comparateur est amené à un circuit de commande d'un étage de sortie 14 relié par des bornes 15 à un circuit extérieur de charge et d'alimentation.

Le détecteur de proximité comprend en outre un oscillateur pilote 16 qui délivre une oscillation de fréquence déterminée invariable quand l'objet métallique s'approche ou s'éloigne. Cet oscillateur peut être du type à quartz. L'oscillation disponible à la sortie A de l'oscillateur pilote 16, et par exemple divisée pour obtenir le niveau de fréquence voulu F, est appliquée à l'entrée de commande 17 d'une source de courant 18 qui alimente l'oscillateur 10 pour exciter son circuit résonnant parallèle 11. Le courant fourni au circuit LC 11 à partir de la source de courant est un courant périodique de fréquence imposée et égale à la fréquence propre du circuit oscillant 11. Un circuit 19 d'accord en fréquence est prévu pour ajuster la fréquence propre du circuit LC 11 en l'absence d'objet métallique sur la fréquence de l'oscillateur pilote 16 ; un bon accord permettra d'augmenter la précision de détection. Des moyens de couplage décrits par la suite assurent un couplage lâche de l'oscillateur analogique 10 avec l'oscillateur pilote 16.

Il convient de noter que les éléments 12, 13, 18 peuvent se trouver inclus dans des circuits intégrés disponibles dans le commerce.

Dans le mode de réalisation de la figure 2, l'oscillateur analogique 10 est du type à émetteurs couplés. Il comprend deux transistors bipolaires T1, T2 dont les émetteurs sont interconnectés et reliés à une borne principale de la source de courant 18 dont l'autre borne principale est à la masse. Une tension de polarisation $V_{cc}$ engendrée en interne ou à partir du circuit externe de charge et d'alimentation est reliée à la base de T1 et au collecteur de T2 ; tandis que le point B est relié d'une part à la base de T2 et d'autre part au collecteur de T1. Le circuit résonnant 11 est connecté entre $V_{cc}$ et le point B ; la résistance de perte équivalente du circuit 11 a été représentée par la résistance R. A la résonance, le courant drainé par la source de courant 18 est égal au courant traversant la résistance de perte.

Une impédance de couplage Z, par exemple constituée par une résistance, relie les points A et B pour élargir le domaine d'accrochage des deux oscillateurs 10 et 16.

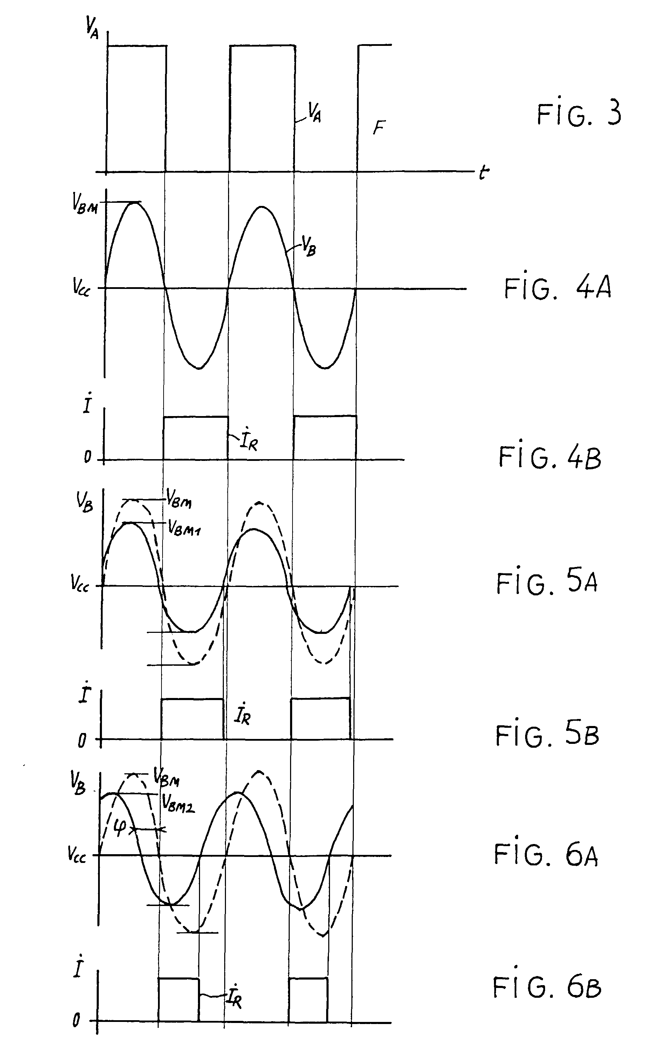

Les figures 3 à 6B vont permettre d'expliquer le fonctionnement du détecteur de proximité inductif conforme à l'invention. La figure 3 représente l'oscillation délivrée par l'oscillateur pilote 16 sous forme d'onde de tension carrée $V_A$ de fréquence F. En l'absence d'objet métallique, les créneaux du courant périodique I de fréquence F issu de la source de courant 18, qui est commandée en tension par l'oscillateur pilote 16, sont en phase avec les alternances négatives de l'onde de tension $V_A$ (voir figure 4B). Le circuit oscillant 11 engendre une oscillation $V_B$ qui est en phase avec l'oscillation pilote $V_A$ et dont la valeur oscille autour de $V_{cc}$ avec une amplitude au plus égale au $V_{BE}$ de T1, T2 (voir figure 4A).

Lorsqu'un objet métallique ferreux ou magnétique s'approche, la résistance de perte du circuit oscillant diminue, l'oscillation $V_B$ est amortie et sa valeur crête diminue donc de la valeur $V_{BM}$ à la valeur $V_{BM1}$ (figure 5A). La fréquence F étant choisie de l'ordre de quelques centaines de kHz, la présence de l'objet modifiée peu l'inductance L et l'oscillation $V_B$ n'est que très peu déphasée par rapport à l'oscillation pilote $V_A$. Le courant injecté dans le circuit oscillant reste donc sensiblement en phase avec la tension $V_B$ à ses bornes (figure 5B).

Lorsqu'un objet métallique non ferreux ou amagnétique s'approche, la résistance de perte du circuit oscillant diminue peu, tandis que son inductance se réduit de manière importante. L'oscillation $V_B$ est donc peu amortie, mais a tendance à se déphaser de manière significative, comme il est indiqué en tirets sur la figure 6A, par rapport à l'oscillation pilote $V_A$. Comme l'oscillation $V_A$ continue de piloter en tension la source de courant 18, celle-ci continue d'être passante pour les alternances négatives de $V_A$. Comme l'oscillateur 10 ne permet de son côté l'injection du courant I que pendant les alternances négatives de l'oscillation $V_B$, il en résulte que les créneaux de courant voient leur largeur amputée d'autant plus que le déphasage est grand (voir figure 6B) ; le front montant de chaque créneau est synchrone avec le front descendant de $V_A$, tandis que le front descendant du créneau est synchrone avec le passage par $V_{CC}$ de $V_B$ en valeurs croissantes. L'énergie délivrée par la source de courant au circuit oscillant étant dès lors une fonction analogique de l'approche de l'objet amagnétique, l'amplitude crête $V_{BM2}$ de l'oscillation $V_B$ peut être amenée à une valeur proche de l'amplitude crête $V_{BM1}$ qui aurait été obtenue avec un objet magnétique à la même portée.

Il convient d'observer que l'oscillateur analogique se comporte pour ainsi dire en démodulateur de phase. Les portées de détection d'objets magnétiques et amagnétiques peuvent être ajustées plus finement en désaccordant légèrement la fréquence propre du circuit LC de la fréquence de l'oscillateur pilote. Le couplage obtenu permet une tolérance suffisante d'écart de la fréquence propre de l'oscillateur analogique par rapport à celle de l'oscillateur pilote, de manière à éviter leur décrochage.

En pratique, le détecteur de proximité inductif décrit nécessite donc un étalonnage consistant à accorder, au moyen du réglage du circuit d'accord 19, la fréquence propre du circuit oscillant 11 avec la fréquence F délivrée par l'oscillateur pilote 16. Il nécessite aussi un étalonnage, usuel pour les détecteurs de proximité, de l'amplitude du courant excitant l'oscillateur analogique de manière à définir la portée de détection comme étant la distance de l'objet pour laquelle la tension crête $V_{BM}$ de l'oscillateur analogique est égale à la valeur de seuil $V_S$ du circuit de traitement.

Dans une application dérivée, le détecteur universel décrit peut être adapté à une détection sélective d'objets magnétiques et d'objets amagnétiques si l'on choisit la fréquence F inférieure à une fréquence dite critique et si l'on inclut dans le circuit de traitement 13 une logique et un traitement électronique approprié des grandeurs de déphasage et de réduction d'amplitude. Cette fréquence critique peut être définie comme étant la fréquence d'excitation du circuit LC pour laquelle l'inductance de la bobine reste pratiquement constante quand on fait varier la distance d'un objet magnétique par rapport au détecteur. Dans ce cas (voir figure 7), le circuit de traitement 13 peut comprendre un détecteur d'amplitude 13a et un détecteur de phase 13b délivrant un signal d'amortissement et respectivement un signal de déphasage lorsque l'amplitude et respectivement le déphasage de l'oscillation $V_B$ atteignent un seuil respectif $V_S$, $\varphi_S$ ; le circuit de traitement comprend alors aussi une logique de discrimination 13c traitant ces signaux respectifs pour distinguer le caractère magnétique ou non magnétique de l'objet détecté.

## Revendications

1. Détecteur de proximité inductif pour la détection d'objets métalliques magnétiques et amagnétiques comprenant:

   - un oscillateur analogique (10) muni d'un circuit oscillant LC (11) et alimenté par une source de courant (18), l'oscillateur étant agencé pour traduire l'approche d'un objet en une variation analogique d'une grandeur caractéristique de l'oscillation, notamment de son amplitude,
   - un circuit de traitement (13) de l'amplitude de l'oscillation,

     caractérisé par le fait qu'il comprend :

   - un oscillateur pilote (16) délivrant une onde pilote de fréquence fixe (F) et couplé à une entrée de commande (17) de la source de courant (18) de l'oscillateur analogique (10),
   - l'oscillateur analogique et l'oscillateur pilote étant accordés par des moyens d'accord en fréquence (19),
   - la source de courant délivrant en présence et en l'absence d'objet un courant périodique de fréquence égale à la fréquence (F) de l'onde pilote et en phase avec celle-ci, le courant injecté dans le circuit oscillant restant sensiblement constant à l'approche d'un objet magnétique et étant fonction analogique de l'approche d'un objet amagnétique.

2. Détecteur selon la revendication 1, caractérisé par le fait que le courant périodique (I) traversant la résistance de pertes équivalente (R) du circuit oscillant (11) se présente sous forme de créneaux de largeur variable en fonction du déphasage (φ) de

l'oscillation ($V_B$) de l'oscillateur analogique par rapport à celle ($V_A$) de l'oscillateur pilote.

3. Détecteur selon la revendication 2, caractérisé par le fait que l'oscillateur analogique (10) est du type à émetteurs couplés, les créneaux du courant périodique étant délivrés par la source de courant (18) pendant les alternances négatives de l'oscillation analogique ($V_B$).

4. Détecteur selon l'une des revendications 1 à 3, caractérisé par le fait que l'oscillateur analogique (10) et l'oscillateur pilote (16) sont reliés par une impédance de couplage (Z) déterminée pour élargir leur domaine d'accrochage.

5. Détecteur selon la revendication 4, caractérisé par le fait que la fréquence de l'oscillateur analogique est sous-critique et que le circuit de traitement comprend un détecteur d'amplitude et un détecteur de phase délivrant un signal d'amortissement et respectivement un signal de déphasage lorsque l'amplitude et respectivement le déphasage de l'oscillation ($V_B$) de l'oscillateur analogique (10) atteignent un seuil respectif, ainsi qu'une logique de discrimination traitant ces signaux pour distinguer un objet magnétique d'un objet amagnétique.

## Patentansprüche

1. Induktiver Näherungsschalter für die Detektion von magnetischen oder unmagnetischen Metallgegenständen, mit :

   - einem Analogoszillator (10), ausgestattet mit einem LC-Schwingkreis (11) und versorgt von einer Stromquelle (18), wobei der Oszillator vorgesehen ist, um die Annäherung eines Gegenstands in eine analogische Schwankung einer für die Oszillation kennzeichnende Grösse zu übersetzen,
   - einem Verarbeitungskreis (13) der Oszillations-Amplitude, insbesondere seiner Amplitude,

     dadurch gekennzeichnet, dass er umfasst :

   - einen Pilot-Oszillator (16), der eine Pilotwelle mit fester Frequenz (F) liefert und an einen Steuereingang (17) der Stromquelle (18) des AnalogOszillators (10) angekoppelt ist,
   - wobei der Analogoszillator und der Pilot-Oszillator von Frequenzabstimmungsmitteln (19) abgestimmt werden,
   - die Stromquelle, die in Anwesenheit oder in Abwesenheit eines Gegenstands einen periodischen Strom mit der gleichen Frequenz liefert wie die Frequenz (F) der Pilotwelle und in Phase mit derselben, wobei der in den Schwingkreis eingeleitete Strom bei der Annäherung eines magnetischen Gegenstands etwa konstant bleibt und analogisch Funktion der Annäherung eines unmagnetischen Gegenstands ist.

2. Schalter nach Anspruch 1, dadurch gekennzeichnet, dass der periodische Strom (1), der den äquivalenten Verlustwiderstand (R) des Schwingkreises (11) durchläuft, die Form von Impulsen von entsprechend der Phasenverschiebung (φ) der Oszillation ($V_B$) des Analogoszillators in Bezug auf diejenige ($V_A$) des Pilot-Oszillators variabler Breite aufweist.

3. Schalter nach Anspruch 2, dadurch gekennzeichnet, dass der Analogoszillator (10) des Typs mit gekoppelten Sendern ist, wobei die Impulse des periodischen Stroms von der Stromquelle (18) während der negativen Wechselfolgen der analogischen Oszillation ($V_B$) geliefert werden.

4. Schalter nach einem der Ansprüche 1 bis 3, dadurch gekennzeichnet, dass der Analogoszillator (10) und der Pilot-Oszillator (16) über eine bestimmte Kopplungsimpedanz (Z) verbunden sind, um ihren Einfangbereich zu erweitern.

5. Schalter nach Anspruch 4, dadurch gekennzeichnet, dass die Frequenz des Analogoszillators unterkritisch ist, und dass der Verarbeitungskreis einen Amplituden- und einen Phasendetekor umfasst, die ein Dämpfungssignal und jeweils ein Phasenverschiebungssignal liefern, wenn die Amplitude und jeweils die Phasenverschiebung der Oszillation ($V_B$) des Analogoszillators (10) einen jeweiligen Grenzwert erreichen, sowie eine Diskriminationslogik, die diese Signale verarbeitet, um einen magnetischen Gegenstand von einem unmagnetischen Gegenstand zu unterscheiden.

**Claims**

1. An inductive proximity detector for the detection of magnetic and non-magnetic metallic objects including :

- an analogue oscillator (10) provided with an LC oscillating circuit (11) and powered by a current source (18), the oscillator being arranged to translate the approach of an object into an analogue variation of a quantity characteristic of the oscillation, including its amplitude,
- a circuit for processing the oscillation amplitude,

    characterised by the fact that it includes :

- a master oscillator (16) supplying a master wave of fixed frequency (F) and coupled to the control input (17) of the current source (18) of the analogue oscillator (10),
- the analogue oscillator and the master oscillator being tuned by frequency tuning means (19),
- the current source supplying, in the presence and in the absence of an object, an oscillating current of frequency equal to the frequency (F) of the master wave and in phase with it, the current injected into the oscillating circuit remaining approximately constant when a magnetic object approaches and being an analogue function of the approach of a non-magnetic object.

2. A detector according to Claim 1, characterised by the fact that the oscillating current (I) passing through the equivalent loss resistance (R) of the oscillating circuit (11) has a square wave shape with pulses of width that varies as a function of the phase shift (φ) of the oscillation ($V_B$) of the analogue oscillator with respect to that of the master oscillator ($V_A$).

3. A detector according to Claim 2, characterised by the fact that the analogue oscillator (10) is of the coupled emitter type, the pulses of the oscillating current being supplied by the current source (18) during the negative half cycles of the analogue oscillations ($V_B$).

4. A detector according to one of Claims 1 to 3 characterised by the fact that the analogue oscillator (10) and the master oscillator (16) are connected through a predetermined coupling impedance (Z) in order to enlarge their capture range.

5. A detector according to Claim 4, characterised by the fact that the frequency of the analogue oscillator is sub-critical and that the processing circuit includes an amplitude detector and a phase detector supplying respectively a damping signal and a phase shift signal when respectively the amplitude the phase shift ($V_B$) of the analogue oscillator (10) reach a respective threshold, and a discrimination logic which processes these signals in order to distinguish a magnetic object from a non-magnetic object.

FIG. 1

FIG. 2

FIG. 7

FIG. 3

FIG. 4A

FIG. 4B

FIG. 5A

FIG. 5B

FIG. 6A

FIG. 6B